# EUROPEAN PATENT APPLICATION

(11) **EP 4 693 370 A1**
(43) Date of publication of application: **11.02.2026**
(21) Application number: 24780671.4
(22) Date of filing: 28.03.2024
(51) Int. Cl.: H01L 21/02, H01L 21/304, H01L 21/683

(54) **SUBSTRATE SEPARATION APPARATUS, SUBSTRATE PROCESSING APPARATUS, AND SUBSTRATE SEPARATION METHOD**

(30) Priority: 31.03.2023 JP 2023059449; 31.03.2023 JP 2023059447; 31.03.2023 JP 2023059448
(71) Applicant: Shibaura Mechatronics Corporation, Yokohama-shi, Kanagawa 247-8610 (JP)
(72) Inventor: MOCHIZUKI, Yosuke, Yokohama-shi, Kanagawa 247-8610 (JP); AOYAGI, Hitoshi, Yokohama-shi, Kanagawa 247-8610 (JP); OWARI, Shunta, Yokohama-shi, Kanagawa 247-8610 (JP)
(74) Representative: Hoffmann Eitle
(86) International application number: PCT/JP2024/012710
(87) International publication number: WO 2024/204571

(57) **Abstract**

A substrate separation apparatus, a substrate processing apparatus and a substrate separation method are provided that can supply a fluid to an outer periphery of bonded substrate with good positional accuracy and perform reliable separation. The substrate separation apparatus of the present disclosure includes: a holding part 10 configured to hold and rotate a bonded substrate S formed by bonding a pair of substrates Sa and Sb together; a nozzle 30 configured to separate the bonded substrate S by injecting a fluid toward an outer periphery of the bonded substrate S under rotation; and a nozzle drive part 40 configured to change a direction of fluid injection from the nozzle 30 between a first direction which is a direction extending along a tangent to the outer periphery of the bonded substrate S and a second direction which is a direction facing a center of the bonded substrate S.

## Description

### TECHNICAL FIELD

The present disclosure relates to a substrate separation apparatus, a substrate processing apparatus, and a substrate separation method.

### BACKGROUND

In the process of manufacturing a three-dimensional semiconductor device, a technique of bonding and separating two substrates is used to allow a layer formed on one substrate to be transferred to the other substrate, thereby forming a uniform thin film.

As such a technique for separating substrates, a technique has been proposed in which the opposing surfaces of a bonded substrate obtained by bonding two substrates are sandwiched and held between a pair of holders, and high-pressure water (water jet) is supplied from a nozzle toward the outer periphery of the bonded substrate while rotating the bonded substrate, thereby separating the bonded substrate through the use of the wedge effect of a fluid.

### [Prior Art Documents]

### [Patent Documents]

Patent Document 1: Japanese Patent Laid-Open Publication No. 2002-353081

### SUMMARY

The fluid supplied from the nozzle of water jet to the outer periphery of the bonded substrate spreads in a spray-like manner from an injection port. Therefore, if the distance between the nozzle and the outer periphery of the bonded substrate is large, it becomes difficult to supply the fluid to the appropriate position on the bonded substrate with good positional accuracy.

Some embodiments of the present disclosure provide a substrate separation apparatus, a substrate processing apparatus, and a substrate separation method capable of supplying a fluid to the outer periphery of a bonded substrate with good positional accuracy and performing reliable separation.

According to one embodiment of the present disclosure, there is provided a substrate separation apparatus including: a holding part configured to hold and rotate a bonded substrate formed by bonding a pair of substrates together; a nozzle configured to separate the bonded substrate by injecting a fluid toward an outer periphery of the bonded substrate under rotation; and a nozzle drive part configured to change a direction of injection of the fluid from the nozzle between a first direction which is a direction extending along a tangent to the outer periphery of the bonded substrate and a second direction which is a direction facing a center of the bonded substrate.

According to another embodiment of the present disclosure, there is provided a substrate processing apparatus including: the substrate separation apparatus; and a surface processing apparatus configured to process a surface of a separated substrate.

According to yet another embodiment of the present disclosure, there is provided a substrate separation method including: holding and rotating, by a holding part, a bonded substrate formed by bonding a pair of substrates together; separating the bonded substrate by injecting a fluid from a nozzle toward an outer periphery of the bonded substrate under rotation; and changing, by a nozzle drive part, a direction of injection of the fluid from the nozzle between a first direction which is a direction extending along a tangent to the outer periphery of the bonded substrate and a second direction which is a direction facing a center of the bonded substrate.

According to the present disclosure in some embodiments, it is possible to supply a fluid to the outer periphery of a bonded substrate with good positional accuracy and perform reliable separation.

### BRIEF DESCRIPTION OF DRAWINGS

FIG. 1 is a side view showing a separation process of a substrate separation apparatus according to an embodiment.
FIG. 2 is a plan view showing a bonded substrate and a positioning part when the bonded substrate is loaded.
FIG. 3 is a plan view showing the bonded substrate and the positioning part when the bonded substrate is positioned before a separation process.
FIG. 4 is a plan view showing the displacement of a nozzle to a standby position, a separation start position, and a center separation position.
FIG. 5 is a plan view showing the bonded substrate, the positioning part, and the nozzle during separation of the bonded substrate.
FIG. 6 is a plan view showing the bonded substrate, the positioning part, and the nozzle during center separation of the bonded substrate.
FIG. 7 is a flowchart showing a procedure for separating a bonded substrate according to an embodiment.
FIGS. 8A to 8H are explanatory diagrams showing a process from loading of the bonded substrate to separation thereof according to an embodiment.
FIG. 9 is a plan view showing a modification of the displacement of the nozzle of the substrate separation apparatus according to the embodiment.
FIG. 10 is a plan view showing a substrate processing apparatus provided with the substrate separating apparatus according to the embodiment.

### DETAILED DESCRIPTION

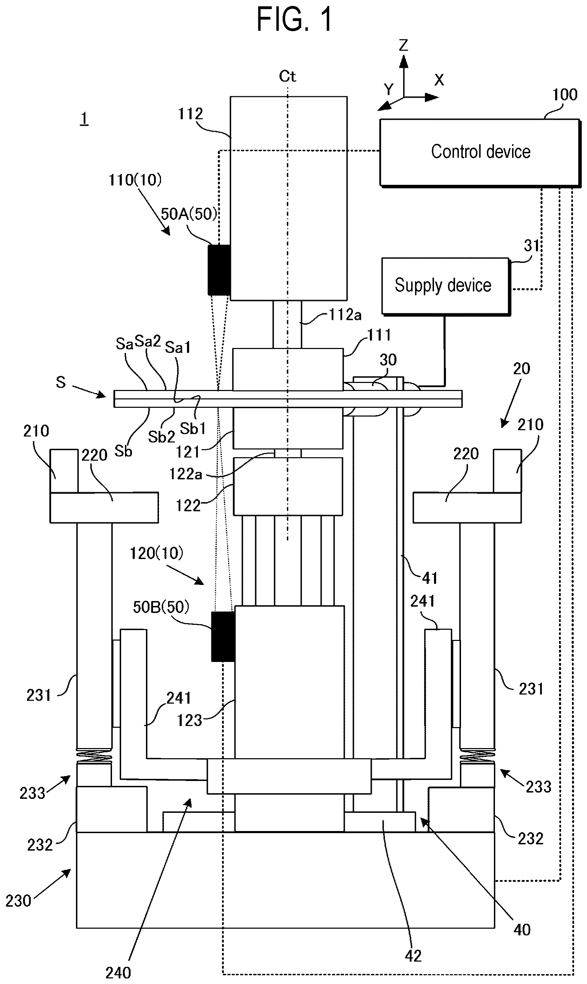

A substrate separation apparatus according to an embodiment will be described with reference to the drawings. The drawings are schematic diagrams. The size, proportions, and the like of each part are exaggerated for ease of understanding. As shown in FIG. 1, the substrate separation apparatus 1 separates a bonded substrate S by injecting a fluid from a nozzle 30. A grip part 210 and a mounting part 220, which are located in the front, are omitted in FIG. 1. In the following description, the direction along the rotation axis of the bonded substrate S is referred to as a Z direction, the direction in which the nozzle 30 injects a fluid in a plane perpendicular to the Z direction is referred to as a Y direction, and the direction perpendicular to the Y direction is referred to as an X direction. The rotation plane of the bonded substrate S is parallel to an XY plane. In this embodiment, the Z direction is the vertical direction, and the X and Y directions are the horizontal direction. However, the installation direction of the substrate separation apparatus 1 is not limited thereto.

The bonded substrate S is a circular substrate formed by bonding a first substrate Sa and a second substrate Sb together. The first substrate Sa has a bonding surface Sa1 and a surface Sa2 opposite to the bonding surface Sa1. The second substrate Sb has a bonding surface Sb1 and a surface Sb2 opposite to the bonding surface Sb1. That is, the bonded substrate S has the surfaces Sa2 and Sb2 which are a pair of circular surfaces and are exposed surfaces opposite the bonded surface of the first substrate Sa and the second substrate Sb. The first substrate Sa is, for example, a substrate obtained by forming a porous layer on the surface of a semiconductor wafer and forming a monocrystalline Si layer on the porous layer. The second substrate Sb is, for example, a substrate obtained by forming a monocrystalline Si layer on the surface of a semiconductor wafer. The bonded substrate S is formed by bonding the first substrate Sa and the second substrate Sb together via an insulating layer formed on the first substrate Sa or the second substrate Sb. In the following description, even if the bonded substrate S is a substrate in which the first substrate Sa and the second substrate Sb are separated, it is still considered to be a bonded substrate S as long as the bonding surfaces Sa1 and Sb1 are overlapping.

The substrate separation apparatus 1 separates the first substrate Sa of the bonded substrate S from the porous layer and forms multiple monocrystalline Si layers on the second substrate Sb. The substrate separation apparatus 1 includes a holding part 10, a positioning part 20, a nozzle 30, a nozzle drive part 40, a displacement detection part 50, and a control device 100.

### [Holding Part]

The holding part 10 holds both surfaces (Sa2 and Sb2) of the bonded substrate S and rotates the bonded substrate S. The holding part 10 includes a first holder 110 and a second holder 120.

### (First Holder)

The first holder 110 includes a first holding body 111 and a support mechanism 112. The first holding body 111 is a circular plate having a diameter smaller than the diameter of the surface of the bonded substrate S. The support mechanism 112 is connected to the center of the surface of the first holding body 111 via a Z-direction support shaft 112a to rotatably support the first holding body 111 so that its center serves as a rotation center Ct. In this embodiment, the support shaft 112a is connected via a pulley and timing belt to a drive source that rotates a second holding body 121 (described below), and is configured to rotate in synchronization with the second holding body 121.

In this embodiment, a surface of the first holding body 111 fixed to the support shaft 112a faces upward, and an opposite surface of the first holding body 111 faces downward. Although not shown, the first holding body 111 has a suction hole opened in the surface that contacts the bonded substrate S. By connecting an exhaust device to this suction hole, one surface of the bonded substrate S (the exposed surface Sa2 of the first substrate Sa) can be suction-held by a negative pressure.

### (Second Holder)

The second holder 120 includes a second holding body 121, a rotational drive part 122, and an attachment/detachment drive part 123. The second holding body 121 is a circular plate having the same diameter as the first holding body 111. The rotational drive part 122 rotates the bonded substrate S. The rotational drive part 122 has a Z-direction drive shaft 122a connected to the center of the second holding body 121, and rotatably supports the second holding body 121. The rotational drive part 122 includes a motor as a drive source for rotating the second holding body 121. The drive shaft 122a is a motor shaft. When the motor is operated, the second holding body 121 rotates about the rotation center Ct.

In this embodiment, the surface of the second holding body 121 attached to the drive shaft 122a faces downward, and the opposite surface of the second holding body 121 faces upward so as to face the first holding body 111. In other words, the first holding body 111 and the second holding body 121 are arranged to face each other at a distance so that their rotation centers Ct coincide with each other. Although not shown, the second holding body 121 has a suction hole formed on the surface that contacts the bonded substrate S. By connecting an exhaust device to the suction hole, the other surface of the bonded substrate S (the exposed surface Sb2 of the second substrate Sb) can be suction-held by a negative pressure.

The attachment/detachment drive part 123 causes the holding part 10 to hold the bonded substrate S. The attachment/detachment drive part 123 moves the second holding body 121 toward and away from the first holding body 111. The attachment/detachment drive part 123 has a cylinder as a drive source. The bonded substrate S is inserted between the first holding body 111 and the second holding body 121, which are spaced apart from each other. By allowing the attachment/detachment drive part 123 to move the second holding body 121 toward the first holding body 111, the bonded substrate S can be sandwiched and held between the first holding body 111 and the second holding body 121.

### [Positioning Part]

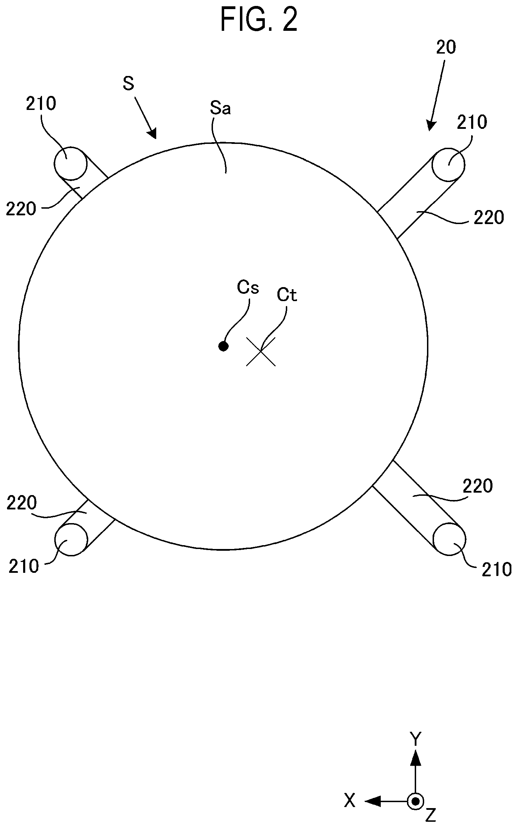

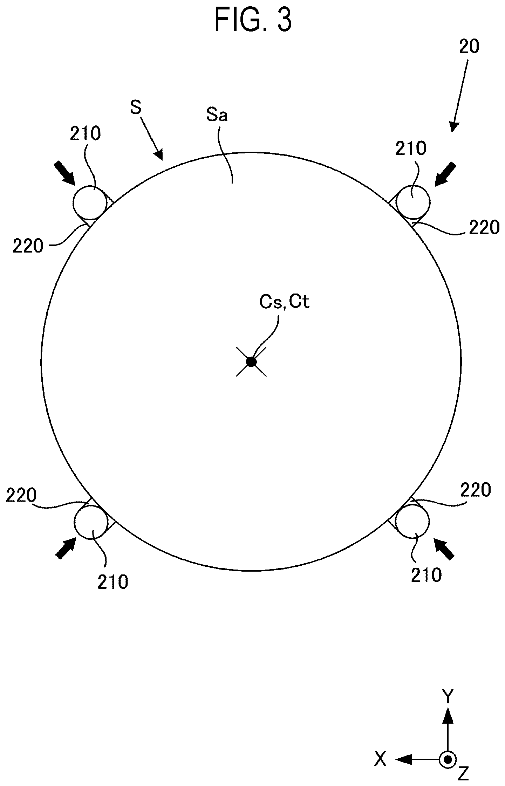

The positioning part 20 positions the center Cs of the bonded substrate S at the rotation center Ct of the holding part 10 *(see* FIGS. 2 and 3). In other words, the center Cs of the bonded substrate S, which is arranged between the first holding body 111 and the second holding body 121, is aligned with the rotation center Ct of the first holding body 111 and the second holding body 121. The positioning part 20 includes a grip part 210, a mounting part 220, an axial drive part 230, and an opening/closing drive part 240.

### (Grip Part)

The grip part 210 grips the outer periphery of the bonded substrate S. The outer periphery of the bonded substrate S is a side surface extending along the outer edge of a circumference. Multiple grip parts 210 are arranged at equal intervals at positions around the holding part 10, i.e., at positions along the outer periphery of the bonded substrate S held by the holding part 10. In this embodiment, the grip parts 210 are four upright pins.

### (Mounting Part)

The mounting part 220 is a part on which the bonded substrate S is mounted. The mounting part 220 has a mounting surface that supports the bonded substrate S. The respective grip parts 210 are attached to the mounting part 220. Four mounting parts 220 are provided in one-to-one correspondence to the grip parts 210. In this embodiment, the surface of the bonded substrate S held by the second holder 120, i.e., the exposed surface Sb2 of the second substrate Sb, is mounted on the mounting part 220.

### (Axial Drive Part)

The axial drive part 230 moves the grip part 210 and the mounting part 220 in an axial direction parallel to the rotation axis of the holding part 10. The axial drive part 230 includes a support column part 231, a biasing part 232, and an absorbing part 233. The support column part 231 is an upright member that supports the grip part 210 and the mounting part 220 at a tip end of the support column part 231. The biasing part 232 is provided to be axially movable by, for example, a drive mechanism such as a cam rotated by a cylinder. The absorbing part 233 is interposed between the biasing part 232 and the support column part 231 to transmit the movement of the biasing part 232 to the support column part 231 while absorbing vibrations from the bonded substrate S. The absorbing part 233 may be, for example, a compression spring, a leaf spring, an elastic body made of rubber or resin, or a cylinder, as long as it is capable of absorbing vibrations.

The opening/closing drive part 240 moves the grip part 210 and the mounting part 220 between a closed position where the grip part 210 contacts the outer periphery of the bonded substrate S and an open position where the grip part 210 is separated from the outer periphery of the bonded substrate S. The position of the grip part 210 is set so that the center Cs of the bonded substrate S is positioned at the rotation center Ct when the grip part 210 is in the closed position. The opening/closing drive part 240 includes an arm 241 that is moved in the radial direction of the bonded substrate S (centripetal direction and centrifugal direction relative to the rotation center Ct) by a drive mechanism such as a cam that is rotated by a cylinder (not shown). The support column part 231 is connected to the arm 241 so as to be axially movable.

### [Nozzle]

The nozzle 30 separates the bonded substrate S into the substrate Sa and the substrate Sb by injecting a fluid toward the outer periphery of the bonded substrate S under rotation. In this embodiment, the nozzle 30 injects a fluid toward the outer periphery of the bonded substrate S, which is held and rotated by the holding part 10, and then injects the fluid toward the outer periphery of the bonded substrate S, which is stationary, by being positioned by the positioning part 20.

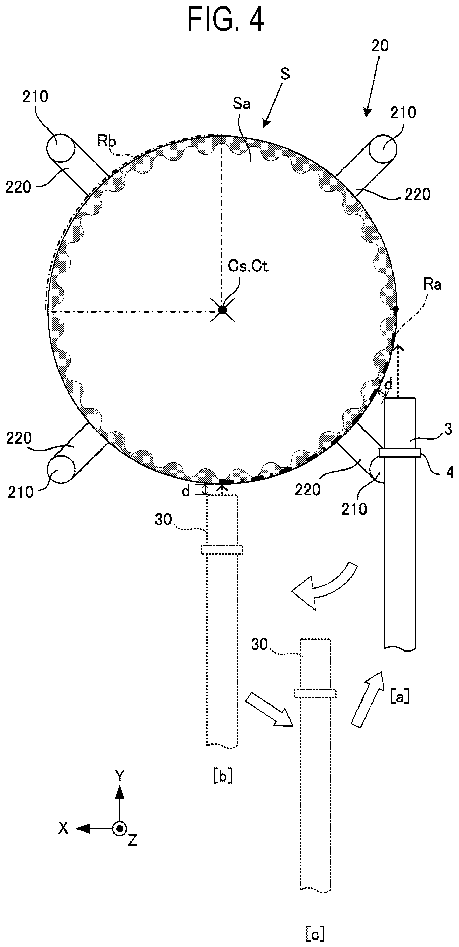

The nozzle 30 of this embodiment is a spraying device that implements water jet machining in which water as a high-pressure fluid (water jet) is sprayed onto an object to perform machining. The nozzle 30 is connected via a pipe, a valve, etc. to a supply device 31 that includes a pump or the like for supplying high-pressure water. The nozzle 30 is configured to be able to inject a high-pressure fluid. The nozzle 30 has a very small hole diameter (0.1 to 1 mm). A thickness of a tip end of the nozzle 30 is large (1 to 5 cm) enough to withstand high-pressure water. As shown in FIG. 4, the injection port at the tip end of the nozzle 30 is provided in a direction as to face the outer periphery of the bonded substrate S. The axis of the nozzle 30 is parallel to the plane of rotation of the bonded substrate S.

### [Nozzle Drive Part]

As shown in FIGS. 4 to 6, the nozzle drive part 40 changes the fluid injection direction of the nozzle 30 between a first direction, which is a direction extending along the tangent to the outer periphery of the bonded substrate S, and a second direction, which is a direction facing the center Cs of the bonded substrate S. In this embodiment, the nozzle drive part 40 can move the nozzle 30 in a direction along the outer periphery of the bonded substrate S. The nozzle drive part 40 includes an approach/separation mechanism 41 and a position adjustment mechanism 42.

### (Approach/Separation Mechanism)

The approach/separation mechanism 41 reciprocates the nozzle 30 in the radial direction of the bonded substrate S toward and away from the outer periphery of the bonded substrate S. In this embodiment, the approach/separation mechanism 41 moves the nozzle 30 along the Y direction. The approach/separation mechanism 41 may be, for example, a ball screw mechanism driven by a servo motor.

### (Position Adjustment Mechanism)

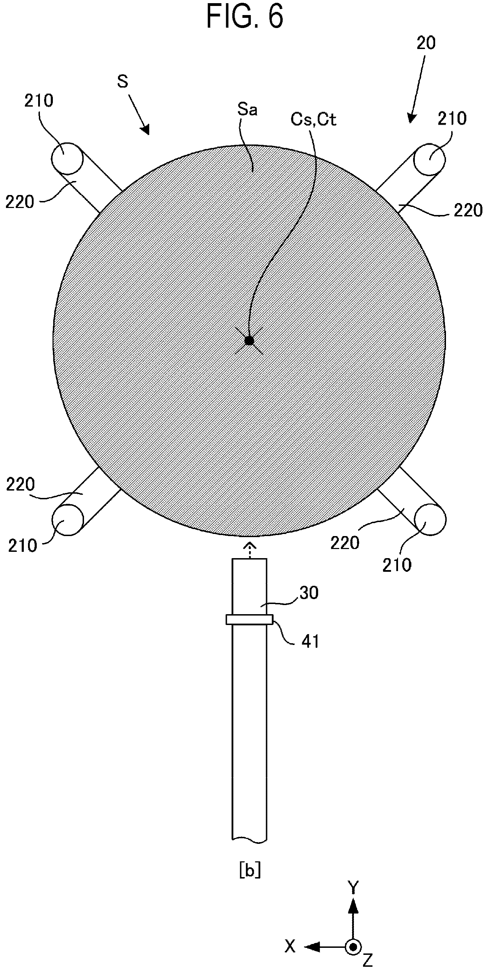

The position adjustment mechanism 42 moves the nozzle 30 between a separation start position *(see* the position of the nozzle 30 indicated by the solid line in FIG. 4) along the tangent to the outer periphery of the bonded substrate S held and rotated by the holding part 10 and a center separation position *(see* FIG. 6) facing the center Cs of the bonded substrate S. In other words, the position adjustment mechanism 42 moves the nozzle 30 along the X direction. The position adjustment mechanism 42 may be, for example, a ball screw mechanism driven by a servo motor.

As shown in FIG. 4, the nozzle 30 can move along an arc trajectory from the separation start position [a] to the center separation position [b] by the approach/separation mechanism 41 and the position adjustment mechanism 42. As a result, the fluid injected from the nozzle 30 is sprayed toward a partial region of the outer periphery of the bonded substrate S as indicated by Ra in FIG. 4. The partial region is a region including an arc with a central angle of 90 degrees on the outer periphery of the bonded substrate S. Since the bonded substrate S rotates at least during separation of the outer periphery, even if the fluid is injected to the partial region of the outer periphery, the injected fluid can reach the entire periphery. Furthermore, as the bonded substrate S is separated, the fluid also reaches the central portion of the bonded substrate S through the gap between the first substrate Sa and the second substrate Sb. Before the start of separation of the bonded substrate S and after the completion of the separation of the bonded substrate S, the approach/separation mechanism 41 and the position adjustment mechanism 42 move the nozzle 30 to a standby position [c] spaced apart from the outer periphery of the bonded substrate S.

The distance d between the injection port of the nozzle 30 positioned in the first direction and the outer periphery of the bonded substrate S is the same as the distance d between the injection port of the nozzle 30 positioned in the second direction and the outer periphery of the bonded substrate S. Thus, the injection port of the nozzle 30 in the first direction and the injection port of the nozzle 30 in the second direction can be positioned as close to the outer periphery of the bonded substrate S as possible.

### [Displacement Detection Part]

As shown in FIG. 1, the displacement detection part 50 detects a change in the surface position of the bonded substrate S when the nozzle 30 injects a fluid. In other words, the displacement detection part 50 detects a change in the surface position due to separation of the rotating bonded substrate S. The change in the surface position refers to a change in the surface position of at least one of the substrates in the direction in which the first substrate Sa and the second substrate Sb are opened as separation progresses (in this embodiment, the height direction). As separation progresses, the first substrate Sa and the second substrate Sb are separated so that their ends have a warped shape. In other words, by detecting a change in the surface position of the bonded substrate S, it is possible to detect the separation status of the bonded substrate S. The displacement detection part 50 may be a sensor that detects the position of the surface of the bonded substrate S in a non-contact manner, such as a laser displacement sensor. The laser displacement sensor is a reflection sensor that detects the position of an object by irradiating the surface of the bonded substrate S with a laser beam and receiving reflected light with a light-receiving element. Furthermore, the laser displacement sensor can detect the position of a desired region of an object by scanning the surface thereof. In this embodiment, the position of the surface of the bonded substrate S in a sector-shaped region indicated by Rb in FIG. 4 is detected by scanning from the outer periphery toward the center Cs.

Displacement detection parts 50 are arranged one by one at positions sandwiching the bonded substrate S so as to detect the positions of both surfaces of the bonded substrate S. In this embodiment, the displacement detection part 50A attached to the support mechanism 112 detects the position of the upper surface of the bonded substrate S (the exposed surface Sa2 of the first substrate Sa), and the displacement detection part 50B attached to the attachment/detachment drive part 123 detects the position of the lower surface of the bonded substrate S (the exposed surface Sb2 of the second substrate Sb).

### [Control Device]

The control device 100, which is a device for controlling the substrate separation apparatus 1, controls the operations of the holding part 10, the positioning part 20, the nozzle 30 and the nozzle drive part 40. The control device 100 can be implemented, for example, by a dedicated electronic circuit or a computer running with a predetermined program.

More specifically, the control device 100 controls the rotation and movement of the second holding body 121 by controlling the rotational drive part 122 and the attachment/detachment drive part 123. The control device 100 also controls the movement of the grip part 210 and the mounting part 220 by controlling the axial drive part 230 and the opening/closing drive part 240. Furthermore, the control device 100 controls the injection of the fluid from the nozzle 30 and the movement of the nozzle 30 by controlling the supply device 31, the approach/separation mechanism 41, and the position adjustment mechanism 42.

In particular, the control device 100 of this embodiment controls the nozzle drive part 40 to move the nozzle 30 in response to a change in the position of the surface of the bonded substrate S detected by the displacement detection part 50. For example, the control device 100 determines the separation status of the bonded substrate S by detecting the amount of change in position at predetermined intervals or continuously using the displacement detection part 50 and determining whether the detected amount of change in position exceeds a predetermined threshold value. If it is determined that separation has occurred, the nozzle drive part 40 moves the nozzle 30 in a direction in which the position of the nozzle 30 is changed from the separation start position [a] toward the center separation position [b]. More specifically, for example, the displacement detection part 50 detects the positions of the surface locations of at least one circumference of the bonded substrate S, and moves the nozzle 30 when the amount of change in position exceeds a predetermined threshold value. Furthermore, for example, the displacement detection part 50 may detect the positions the surface locations of at least one circumference of the bonded substrate S, and when the average amount of change in position for one circumference exceeds a predetermined threshold value, the nozzle drive part 40 may move the nozzle 30. Moreover, for example, the nozzle may be moved when both the amount of change in the position of the surface of the first substrate Sa and the amount of change in the position of the surface of the second substrate Sb exceed a predetermined threshold value. In addition, for example, the nozzle 30 may be moved when a separation distance between the first substrate Sa and the second substrate Sb calculated from the positions of the surface of the first substrate Sa and the surface of the second substrate Sb exceeds a predetermined threshold value. The predetermined threshold value is a value set according to the radial position of the bonded substrate S, and is determined in advance by simulations or experiments.

### [Operation]

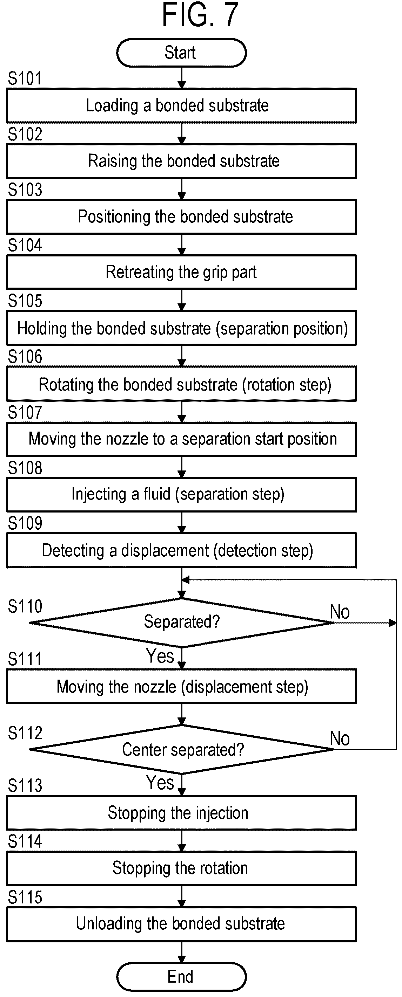

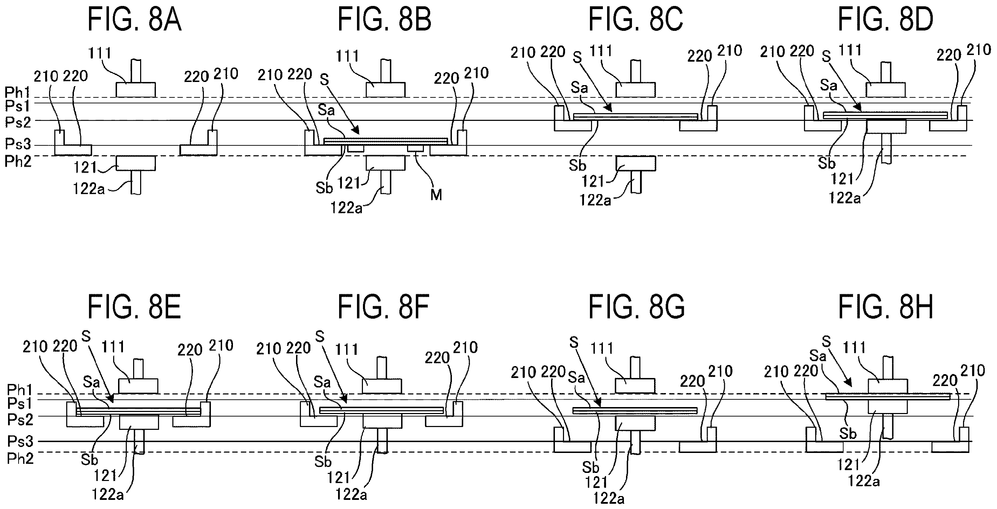

The operation of the substrate separation apparatus 1 will be described with reference to the flowchart shown in FIG. 7 and the explanatory diagram shown in FIGS. 8A to 8H, in addition to the above-described FIGS. 1 to 6. In FIGS. 8A to 8H, Ph1 is a fixed reference position of the lower surface of the first holding body 111, and Ph2 is a delivery position which is the position of the lower surface of the mounting part 220 when the mounting part 220 delivers the bonded substrate S to and from the robot arm M. Ps1 is a separation position which is the height position of the lower surface of the second substrate Sb when the bonded substrate S is sandwiched between the first holding body 111 and the second holding body 121 and is separated by discharging a fluid from the nozzle 30 while being rotated. Ps2 is a receiving position which is the position of the upper surface of the mounting part 220 when the positioning part 20 receives the bonded substrate S from the holding part 10.

First, the second holding body 121 is located at a position spaced apart from the first holding body 111 (FIG. 8A). The grip part 210 and the mounting part 220 are located at the delivery position Ph2 and also at the open position. As shown in FIG. 2, the robot arm M of the transfer device loads the bonded substrate S and mounts the bonded substrate S on the mounting part 220 (FIG. 8B, step S101). The grip part 210 rises to raise the bonded substrate S (FIG. 8C). Furthermore, the second holding body 121 rises to contact the lower surface of the second substrate Sb, thereby raising the bonded substrate S and slightly separating the bonded substrate S from the mounting part 220 (FIG. 8D, step S102).

As shown in FIG. 3, the grip part 210 moves to the closed position to grip the outer periphery of the bonded substrate S, thereby positioning the center Cs of the bonded substrate S at the rotation center Ct (FIG. 8E, step S103). Thereafter, the grip part 210 moves to the open position (FIG. 8F) and retreats together with the mounting part 220 to the delivery position Ph2 (FIG. 8G, step S104). Then, the second holding body 121 rises, brings the bonded substrate S into contact with the first holding body 111, sandwiches and holds the bonded substrate S, positions the bonded substrate S at the separation position Ps1, and holds the bonded substrate S by suction using the negative pressure at the suction hole (FIG. 8H, step S105).

In this state, the second holding body 121 rotates to thereby rotate the bonded substrate S together with the first holding body 111 (rotation step: step S106). Then, as shown in FIG. 4, the nozzle 30 moves from the standby position [c] to the separation start position [a] (step S107) and injects a fluid toward the outer periphery of the bonded substrate S (separation step: step S108). This starts separation of the bonded substrate S.

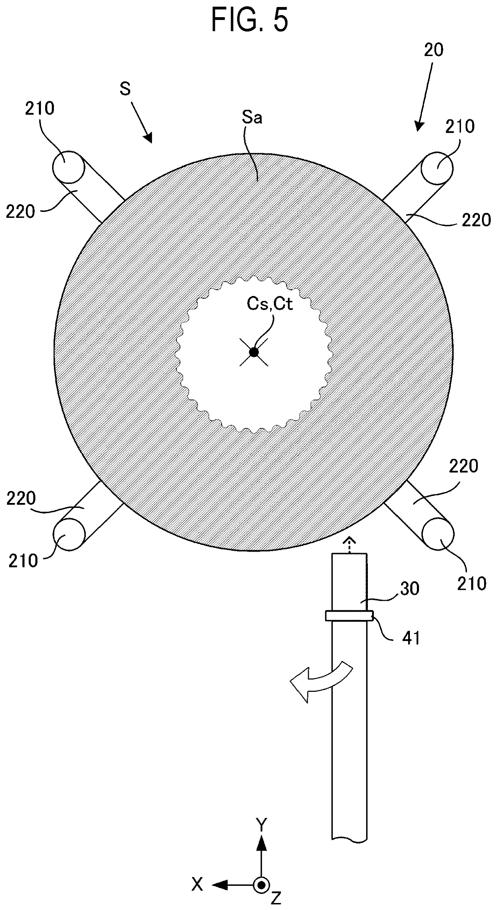

The displacement detection part 50 detects the positions of both surfaces of the bonded substrate S (detection step: step S109). If the control device 100 determines that the bonded surfaces Sa1 and Sb1 corresponding to that position are separated (YES in step S110), as shown in FIG. 5, the nozzle 30 is moved to follow the separated region (indicated by shading in the figure). As the nozzle 30 is moved, the detection position of the displacement detection part 50 in the region Rb is moved toward the center Cs of the bonded substrate S (displacement step: step S111). As shown in FIG. 6, the nozzle 30 is moved to the center separation position [b] and injects a fluid toward the center Cs via the outer periphery of the bonded substrate S. Then, by detecting the passage of a predetermined time until the center Cs is separated, the control device 100 determines that the center Cs of the bonded substrate S is separated (YES in step S112), and stops injecting the fluid from the nozzle 30 (step S113). When the rotation of the first holding body 111 and the second holding body 121 is stopped, the rotation of the bonded substrate S is stopped (step S114).

Thereafter, the negative pressure supplied to the first holding body 111 and the second holding body 121 is released, the second holding body 121 descends and delivers the bonded substrate S to the mounting part 220, and the robot arm M of the transfer device lifts the bonded substrate S from the lower surface side of the bonded substrate S and unloads the bonded substrate S *(see* FIGS. 8D, 8C and 8B, and step S115).

### [Effects]

(1) The substrate separation apparatus 1 of this embodiment includes: a holding part 10 configured to hold and rotate a bonded substrate S formed by bonding a pair of substrates Sa and Sb together; a nozzle 30 configured to separate the bonded substrate S by injecting a fluid toward an outer periphery of the bonded substrate S under rotation; and a nozzle drive part 40 configured to change a direction of fluid injection from the nozzle 30 between a first direction which is a direction extending along a tangent to the outer periphery of the bonded substrate S and a second direction which is a direction facing the center Cs of the bonded substrate S.

Furthermore, the substrate separation method of this embodiment includes: a rotation step of holding and rotating, by a holding part 10, a bonded substrate S formed by bonding a pair of substrates Sa and Sb together; a separation step of separating the bonded substrate S by injecting a fluid from a nozzle 30 toward an outer periphery of the bonded substrate S under rotation; and a displacement step of changing, by a nozzle drive part 40, a direction of fluid injection from the nozzle 30 between a first direction which is a direction extending along a tangent to the outer periphery of the bonded substrate S and a second direction which is a direction facing the center Cs of the bonded substrate S.

For this reason, from the start of separation to the completion of separation, the fluid from the nozzle 30 can be continuously injected toward a separable location close to the bonded substrate S in accordance with the separation status in which separation progresses from the outer periphery toward the center Cs. Therefore, the fluid can be supplied to the bonded substrate S with good positional accuracy, enabling reliable separation. Furthermore, if the fluid is merely continuously injected toward the center Cs of the bonded substrate S, a high-pressure fluid may accumulate at the center Cs, causing cracks or chipping. However, since the injection direction is changed from the direction extending along the tangent to the direction facing the center Cs, the fluid is easily injected and damage to the bonded substrate S is reduced.
(2) The nozzle drive part 40 moves the nozzle 30 in a direction extending along the outer periphery of the bonded substrate S. This allows the nozzle 30 to follow the separation location while maintaining the distance from the outer periphery at a distance that allows separation by the injected fluid.
(3) a distance d between an injection port of the nozzle 30 positioned in the first direction and the outer periphery of the bonded substrate S is the same as a distance d between the injection port of the nozzle 30 positioned in the second direction and the outer periphery of the bonded substrate S. Therefore, the distance that allows separation by the injected fluid can be maintained while preventing the injection port of the nozzle 30 from interfering with the outer periphery of the bonded substrate S.
(4) The substrate separation apparatus 1 further includes a displacement detection part 50 configured to detect a change in the position of the surface of the bonded substrate S when the nozzle 30 injects the fluid, and the nozzle drive part 40 changes the direction of fluid injection from the nozzle 30 in response to the change in the position of the surface of the bonded substrate S detected by the displacement detection part 50. Thus, the direction of fluid injection from the nozzle 30 can be changed to follow the separation location moving from the outer periphery of the bonded substrate S toward the center Cs thereof. Therefore, the nozzle 30 can be prevented from moving while leaving unseparated locations, thereby reducing separation defects. Furthermore, the direction of fluid injection from the nozzle 30 can be changed and the injection can be stopped in accordance with the progress of separation, thereby eliminating waste of the fluid.

### [Modifications]

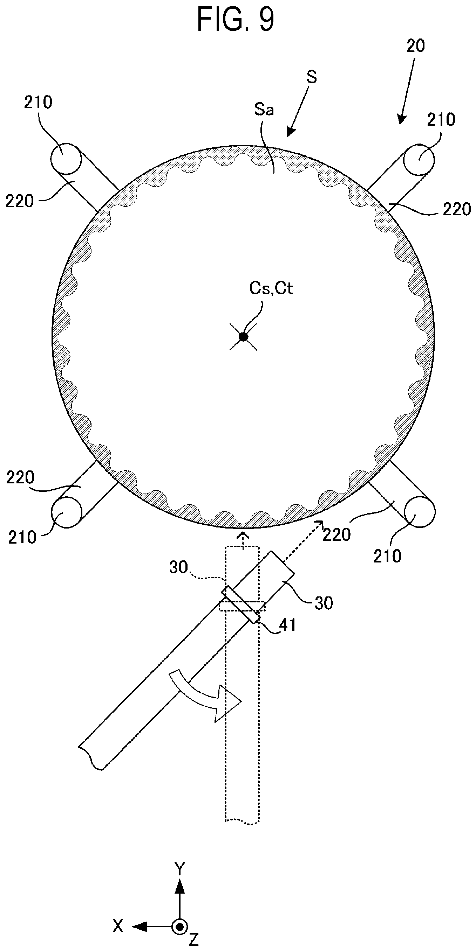

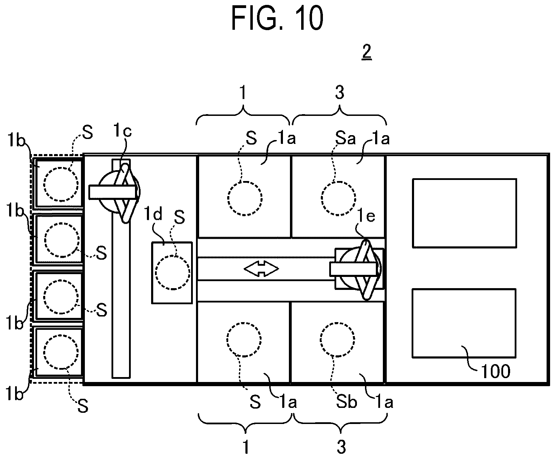

The following modifications are also applicable to this embodiment.
(1) As shown in FIG. 9, the nozzle drive part 40 may change the direction of fluid injection from the nozzle 30 between a first direction and a second direction by rotating the nozzle 30 in a direction parallel to the rotation plane of the bonded substrate S. In other words, the nozzle drive part 40 may be provided with a rotation mechanism including a drive source such as a motor whose drive shaft is connected to the nozzle 30, thereby enabling the nozzle 30 to be driven in a θ direction. This can reduce the movement area of the nozzle 30 compared to a case where the nozzle 30 is moved horizontally in a direction perpendicular to its axis as described above. As a result, it is possible to reduce the installation area of the substrate separation apparatus 1.
(2) In the above-described embodiment, the nozzle drive part 40 continuously changes the direction of fluid injection from the nozzle 30. However, the injection direction may be intermittently changed between the first direction and the second direction. For example, a plurality of stop positions is set between the first direction and the second direction, and the nozzle 30 is temporarily stopped at the plurality of stop positions to inject the fluid depending on the progress of separation. Since the peripheral velocity varies between the outer periphery and the center Cs of the bonded substrate S, continuous injection would result in a location where the amount of fluid injected would be excessive. However, by stopping at each stop position to inject the fluid and then moving after separation to the relevant location has been completed, it is possible to reliably perform separation while preventing fluid waste.
(3) The detection of a change in the position by the displacement detection part 50 is more accurate when detecting both surfaces of the bonded substrate S. However, since the positions of both surfaces of the bonded substrate S are changed during separation, the apparatus may be simplified by being configured to detect a change on either one of the surfaces.
(4) The progress of separation of the bonded substrate S may be determined based on a time previously determined by experiments or simulations. In this case, the control device 100 controls the nozzle drive part 40 so that the nozzle 30 is moved after a certain period of time has elapsed.
(5) In order for the positioning part 20 to position the bonded substrate S, the number of positions at which the positioning part 20 contacts the outer periphery may be three or more. In other words, the number of the grip parts 210 may be three or more, as long as they can position the center Cs of the circular bonded substrate S.
(6) The axis of rotation of the bonded substrate S by the holding part 10 is not limited to the vertical direction. For example, the holding part 10 may be configured so that the bonded substrate S rotates around a horizontal axis, and the nozzle 30 may be configured to inject a fluid toward the outer periphery of the bonded substrate S in the vertical direction. The holding part 10 only needs to be able to hold and rotate at least one of the two surfaces of the bonded substrate S. Therefore, the holding part 10 may be configured so that the bonded substrate S is held by either the first holding body 111 or the second holding body 121. Furthermore, the rotation drive part 122 may be configured to rotate either the first holding body 111 or the second holding body 121, or both. The attachment/detachment drive part 123 may be configured to move either the first holding body 111 or the second holding body 121, or both.
(7) As shown in FIG. 10, the substrate separation apparatus 1 may be configured as part of a substrate processing apparatus 2. For example, the substrate processing apparatus 2 may be a single-substrate processing apparatus that includes a plurality of chambers 1a configured to accommodate a substrate separation apparatus 1 and a surface processing apparatus 3 for processing the surfaces of the separated first substrate Sa and second substrate Sb, and processes bonded substrates S, which are transferred in a cassette (FOUP) 1b in a previous step, one by one in each chamber 1a. The surface processing apparatus 3 is, for example, a cleaning apparatus that cleans the surfaces of the separated first substrate Sa and second substrate Sb with a cleaning liquid. The bonded substrates S are removed one by one from the cassette 1b by a transfer robot 1c, temporarily mounted on a buffer unit 1d, and then transferred by a transfer robot 1e to each chamber 1a, where they are separated and cleaned. The surface processing apparatus 3 cleans the surfaces of the separated first substrate Sa and second substrate Sb with a cleaning liquid.
(8) While the substrate separation apparatus 1 is described as being configured to separate a bonded substrate formed by bonding two semiconductor wafers together, the present disclosure is not limited thereto. The present disclosure may be applied to any substrate formed by bonding two plates together and separated by the substrate separation apparatus 1. For example, the present disclosure may be applied to a configuration in which a device substrate bonded to a support substrate via an adhesive is separated. Alternatively, the present disclosure may be applied to a single plate that is separated (divided) into two plates by the substrate separation apparatus 1. For example, the present disclosure may be applied to a configuration in which a substrate is separated from an ingot.

### [Other Embodiments]

The present disclosure is not limited to the above-described embodiment and includes other embodiments. The present disclosure also includes combinations of all or any of the above-described embodiments and other embodiments. Furthermore, various omissions, substitutions, and modifications may be made to these embodiments without departing from the scope of the present disclosure. These modifications are also included in the present disclosure.

### EXPLANATION OF REFERENCE NUMERALS

1: substrate, 1a: chamber, 1b: cassette, 1c: transfer robot, 1d: buffer unit, 1e: transfer robot, 2: substrate processing apparatus, 3: surface processing apparatus, 10: holding part, 20: positioning part, 30: nozzle, 31: supply device, 40: nozzle drive part, 41: approach/separation mechanism, 42: position adjustment mechanism, 50, 50A, 50B: displacement detection part, 60: fluid removal part, 61, 61A, 61B: removal nozzle, 62: air supply device, 100: control device, 110: first holder, 111: first holding body, 112: support mechanism, 112a: support shaft, 120: second holder, 121: second holding body, 122: rotational drive part, 122a: drive shaft, 123: attachment/detachment drive part, 210: grip part, 220: mounting part, 230: axial drive part, 231: support column part, 232: biasing part, 233: absorbing part, 240: opening/closing drive part, 241: arm

## Claims

1. A substrate separation apparatus, comprising:
a holding part configured to hold and rotate a bonded substrate formed by bonding a pair of substrates together;
a nozzle configured to separate the bonded substrate by injecting a fluid toward an outer periphery of the bonded substrate under rotation; and
a nozzle drive part configured to change a direction of injection of the fluid from the nozzle between a first direction which is a direction extending along a tangent to the outer periphery of the bonded substrate and a second direction which is a direction facing a center of the bonded substrate.

2. The substrate separation apparatus of Claim 1, wherein the nozzle drive part moves the nozzle in a direction extending along the outer periphery of the bonded substrate.

3. The substrate separation apparatus of Claim 1, wherein a distance between an injection port of the nozzle positioned in the first direction and the outer periphery of the bonded substrate is the same as a distance between the injection port of the nozzle positioned in the second direction and the outer periphery of the bonded substrate.

4. The substrate separation apparatus of Claim 1, wherein the nozzle drive part intermittently changes the direction of injection of the fluid from the nozzle between the first direction and the second direction.

5. The substrate separation apparatus of Claim 1, wherein the nozzle drive part rotates the nozzle in a direction parallel to a rotation plane of the bonded substrate.

6. The substrate separation apparatus of Claim 1, further comprising:
a displacement detection part configured to detect a change in a position of a surface of the bonded substrate when the nozzle injects the fluid,
wherein the nozzle drive part moves the nozzle in response to the change in the position of the surface of the bonded substrate detected by the displacement detection part.

7. A substrate processing apparatus, comprising:
the substrate separation apparatus of any one of Claims 1 to 6; and
a surface processing apparatus configured to process a surface of a separated substrate.

8. A substrate separation method, comprising:
holding and rotating, by a holding part, a bonded substrate formed by bonding a pair of substrates together;
separating the bonded substrate by injecting a fluid from a nozzle toward an outer periphery of the bonded substrate under rotation; and
changing, by a nozzle drive part, a direction of injection of the fluid from the nozzle between a first direction which is a direction extending along a tangent to the outer periphery of the bonded substrate and a second direction which is a direction facing a center of the bonded substrate.
